# EUROPEAN PATENT APPLICATION

(11) **EP 1 598 869 A2**
(43) Date of publication of application: **23.11.2005**
(21) Application number: 05010627.7
(22) Date of filing: 17.05.2005
(51) Int. Cl.: H01L 27/00

(54) **Organic electroluminescence display device and fabricating method thereof**

(30) Priority: 21.05.2004 KR 2004036363
(71) Applicant: LG ELECTRONICS INC., Seoul (KR)
(72) Inventor: Kim, Woo Chan, Seoul (KR); Park, Hong Ki Nr. 208-907, Buk-gu Daegu (KR); Bae, Hyo Dae, Daegu (KR); Tak, Yoon Heung 107-201, Gangbyeon Boseong Apt., Gyeongsangbuk-do (KR)
(74) Representative: Zech, Stefan Markus

(57) **Abstract**

An active matrix organic electro-luminescence display device and a fabricating method thereof for preventing a damage of organic light-emitting layer and a pixel badness are disclosed. In the organic electro-luminescence display device, a thin film transistor array is provided on a substrate. A first electrode is connected to the thin film transistor. At least one insulating film exposes the first electrode and separates each pixel. An organic light-emitting layer overlaps with the first electrode. A second electrode is provided on the organic light-emitting layer.

## Description

This application claims the benefit of Korean Patent Application No. P2004-36363 filed in Korea on May 21, 2004, which is hereby incorporated by reference.

### BACKGROUND OF THE INVENTION

### Field of the Invention

This invention relates to an electro-luminescence display (ELD), and more particularly to an active matrix organic electro-luminescence display device and a fabricating method thereof that are adaptive for preventing a damage of organic light-emitting layer.

### Description of the Related Art

Recently, there have been developed various flat panel display devices reduced in weight and bulk that is capable of eliminating disadvantages of a cathode ray tube (CRT). Such flat panel display devices include a liquid crystal display (LCD), a field emission display (FED), a plasma display panel (PDP) and an electro-luminescence (EL) display, etc. Also, there have been actively processed studies for attempting to make a high display quality and a large-dimension screen of the flat panel display device.

In such flat panel display devices, the PDP has drawbacks in that it has been highlighted as the most advantageous display device to make a light weight, a small size and a large dimension screen because its structure and manufacturing process are simple, but it has low light-emission efficiency and large power consumption. On the other hand, the active matrix LCD employing a thin film transistor (TFT) as a switching device has drawbacks in that it is difficult to make a large dimension screen because a semiconductor process is used, and in that it has large power consumption due to a backlight unit and has a large light loss and a narrow viewing angle due to optical devices such as a polarizing filter, a prism sheet, a diffuser and the like.

Meanwhile, the EL display device is largely classified into an inorganic EL display device and an organic EL display device depending upon a material of a light-emitting layer, and is a self-luminous device. When compared with the above-mentioned display devices, the EL display device has advantages of a fast response speed, large light-emission efficiency, a large brightness and a large viewing angle. The inorganic EL display device has a larger power consumption than the organic EL display device, and can not obtain a higher brightness than the organic EL display device and can not emit various colors such as red(R), green(G) and blue(B) colors. On the other hand, the organic EL display device is driven with a low direct current voltage of tens of volts, and has a fast response speed. Also, the organic EL display device can obtain a high brightness, and can emit various colors of red(R), green(G) and blue(B). Thus, the organic EL display device is suitable for a post-generation flat panel display device.

A system of driving such an organic EL display device can be classified into a passive matrix type and an active matrix type.

The passive matrix organic EL display device has a simple structure to make a simple fabricating method, but has a large power consumption and a difficulty in making a large dimension of display device. Also, the passive matrix organic EL display device has a drawback in that, as the number of wirings is more increased, an aperture ratio is more deteriorated.

On the other hand, the active matrix organic EL display device has an advantage in that it is capable of providing a high light-emission efficiency and a high picture quality.

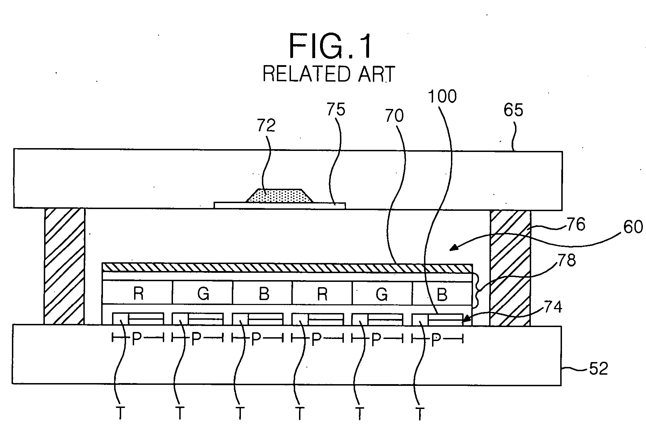

Fig. 1 schematically shows a configuration of a related art active matrix organic EL display device.

Referring to Fig. 1, the organic EL display device includes a thin film transistor (T) array part 74 provided at the upper portion of a transparent substrate 52, and a first electrode 100, an insulating film (not shown) for separating each pixel, an organic light-emitting layer 78 and a second electrode 70 provided at the upper portion of the thin film transistor (T) array part 74.

In this case, the organic light-emitting layer 78 expresses red (R), green (G) and blue (B) colors, and is generally formed by patterning an individual organic material emitting the red, green and blue colors for each pixel P.

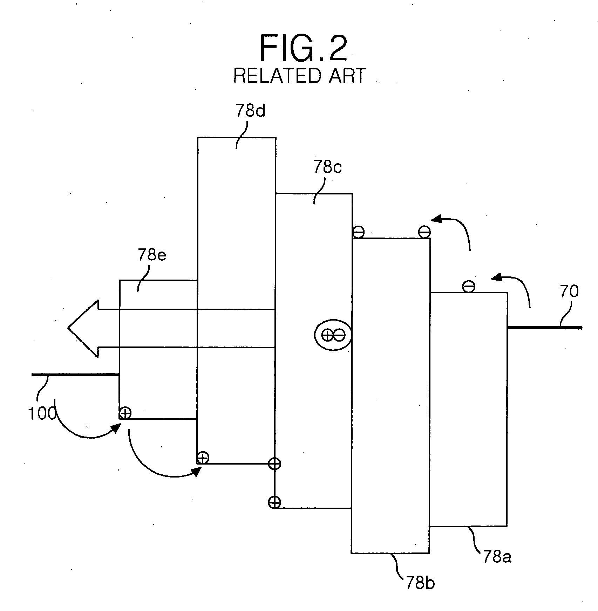

In such an organic EL display device, as shown in Fig. 2, if a voltage is applied between the first electrode 100 and the second electrode 70, then electrons generated from the second electrode 70 are moved, via an electron injection layer 78a and an electron carrier layer 78b, into a light-emitting layer 78c. Further, holes generated from the first electrode 100 are moved, via a hole injection layer 78e and a hole carrier layer 78d, into the light-emitting layer 78c. Thus, electrons and holes fed from the electron carrier layer 78b and the hole carrier layer 78d are collided and re-combined with each other to thereby generate a light. This light is emitted, via the first electrode 100, into the exterior to thereby display a picture.

Such an organic EL display device has a property liable to be deteriorated by moisture and oxygen. In order to overcome this problem, an encapsulation process is carried out. Thus, the substrate 52 provided with the organic EL array 60 is joined to a cap 65 by a sealant 76.

The cap 65 evacuates a heat generated upon light-emission, and protects the organic EL array 60 from an external force or oxygen and moisture in the atmosphere.

After a portion of the packaging plate 78 was etched, a getter 72 is filled into the etched portion and is fixed by a semi-permeable membrane 75.

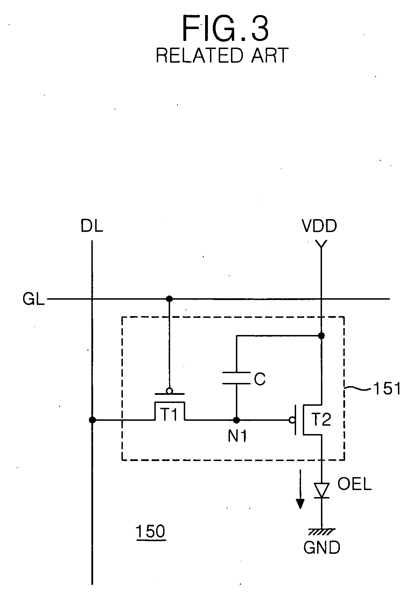

As shown in Fig. 3, the active matrix organic EL display device includes a pixel 150 arranged at an area defined by an intersection between a gate line GL and a data line DL. Each pixel 150 receives a data signal from the data line DL when a gate pulse is applied to the gate line GL, thereby generating a light corresponding to the data signal.

To this end, each pixel 150 includes an EL cell OEL having a cathode connected to a ground voltage source GND, and a cell driver 151 connected to the gate line GL, the data line DL and a supply voltage source VDD and connected to an anode of the EL cell OEL to drive the EL cell OEL. The cell driver 151 includes a switching transistor T1, a driving transistor T2 and a capacitor C.

The switching transistor T1 is turned on when a scanning pulse is applied to the gate line GL, thereby applying a data signal supplied to the data line DL to a first node N1. The data signal applied to the first node N1 is charged into the capacitor C and is supplied to the gate terminal of the driving thin film transistor T2. The driving thin film transistor T2 controls a current amount I fed from the supply voltage source VDD into the EL cell OEL in response to a data signal applied to the gate terminal thereof. The data signal is discharged from the capacitor C even though the switching thin film transistor T1 is turned off, so that the driving thin film transistor T2 applies a current I from the supply voltage source VDD until a data signal at the next frame is supplied, thereby keeping a light-emission of the EL cell OEL.

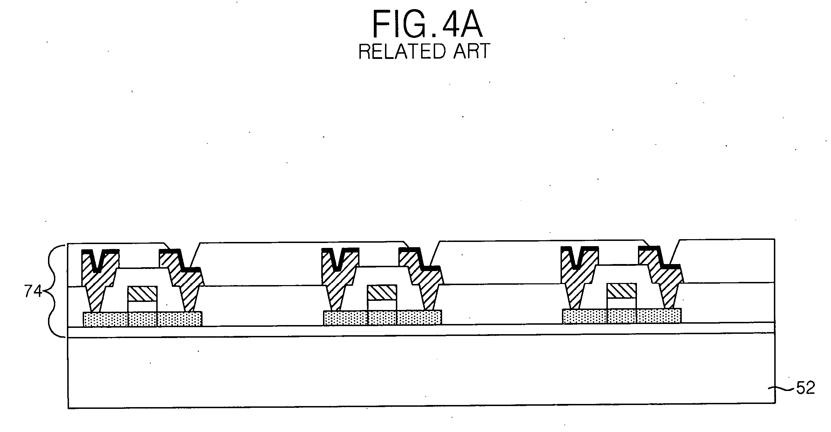

Fig. 4A to Fig. 4E are views for explaining a method of fabricating the related art active matrix organic EL display device.

Firstly, as shown in Fig. 4A, the thin film transistor (T) array part 74 is provided on the substrate 52. Herein, the thin film transistor (T) array part 74 includes a thin film transistor T consisting of the gate electrode, the drain electrode, the source electrode and the semiconductor pattern, etc., and signal lines such as the gate line, etc.

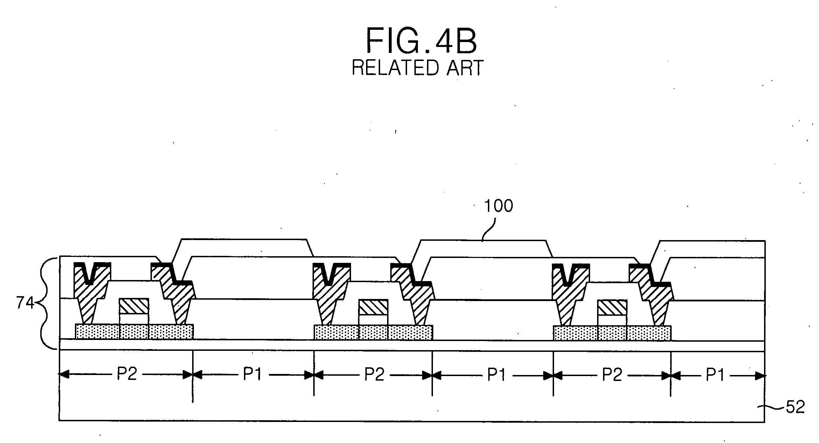

A transparent electrode material is entirely deposited onto the substrate 52 provided with the thin film transistor (T) array part 74 by a deposition technique such as the sputtering, etc. Then, the transparent electrode material is patterned by the photolithography and the etching process. Thus, as shown in Fig. 4B, the first electrode 100 connected to the thin film transistor T and positioned at a light-emission area P1 is provided. Herein, the transparent electrode material is made from indium-tin-oxide (ITO), tin-oxide (TO), indium-zinc-oxide (IZO) or the like.

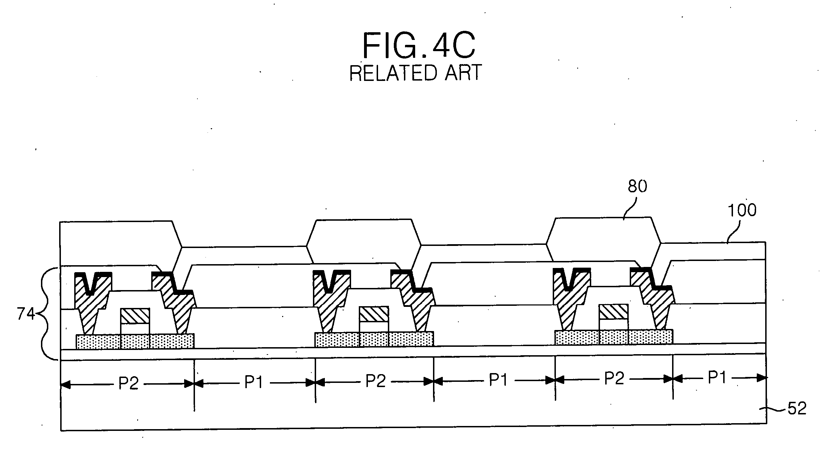

A photo-sensitive insulating material such as polyimide, etc. is deposited onto the substrate 52 provided with the first electrode 100 and then is patterned by the photolithography, thereby providing an insulating film 80 exposing the first electrode 100 at the light-emission area P1 as shown in Fig. 4C.

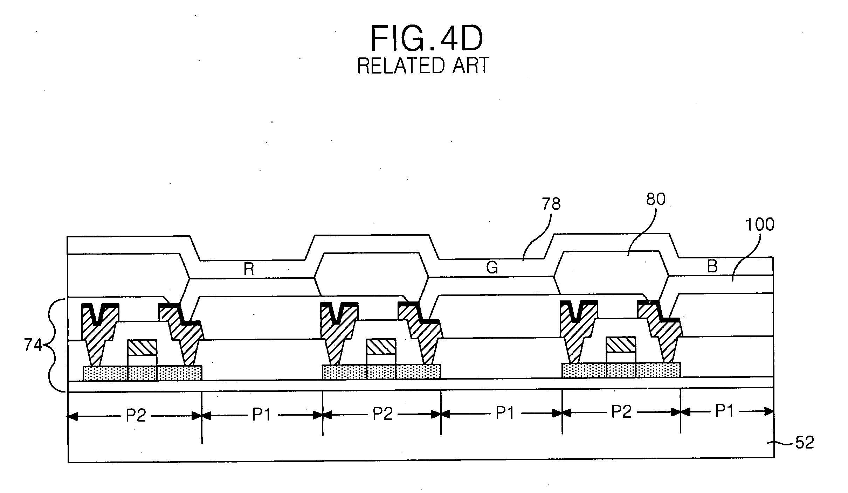

Red(R), green(G) and blue(B) organic materials are deposited onto the substrate 52 provided with the insulating film 80 by a deposition technique such as a vacuum deposition and a thermal growing deposition, etc., thereby providing an organic light-emitting layer 78 as shown in Fig. 4D. In this case, the organic light-emitting layer 78 consists of a hole carrier layer, a hole injection layer, a light-emitting layer, an electron carrier layer and an electron injection layer, etc.

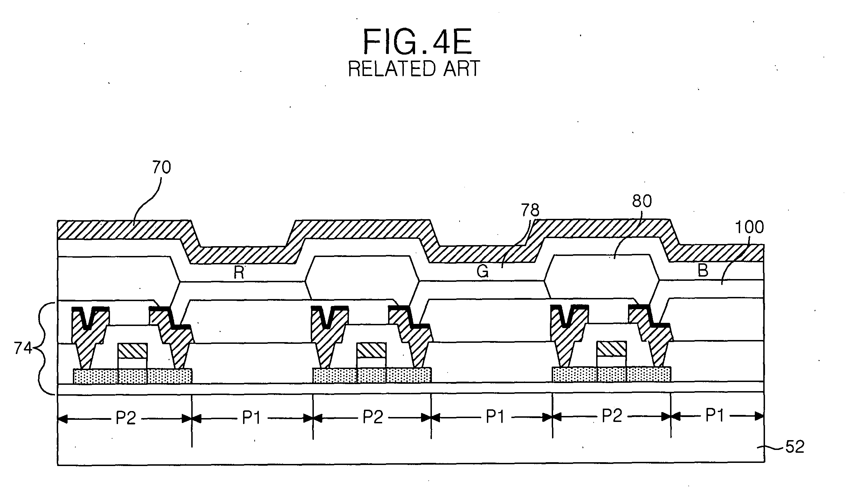

Subsequently, a conductive metal material is deposited onto the organic light-emitting layer 78 by a deposition technique such as the sputtering, etc. to thereby provide the second electrode 70 as shown in Fig. 4E. Herein, the conductive metal material is made from any one selected from aluminum (Al), calcium (Ca) and magnesium (Mg), or is formed by a double metal layer of ritum-fluorine/aluminum (LiF/Al).

As described above, the substrate 52 provided with the thin film transistor (T) array part 74 through the second electrode 70 is joined to the cap 65 by the sealant 76, thereby providing the active matrix organic EL display device.

Meanwhile, in such an active matrix organic EL display device, an organic material adhered onto the surface of the shadow mask upon formation of the organic light-emitting layer 78 applies a scratch against an organic material on the first electrode 100 and exposes the first electrode 100, so that a electrical conduction between the first and second electrodes 100 and 70 may occur frequently.

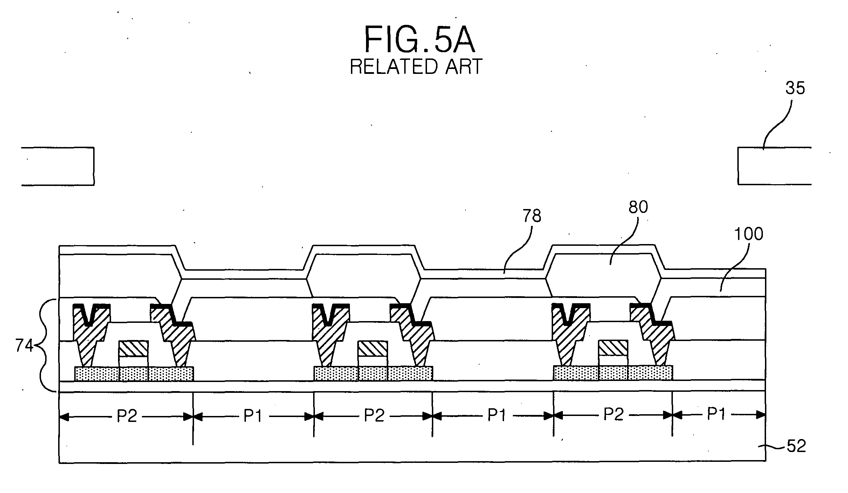

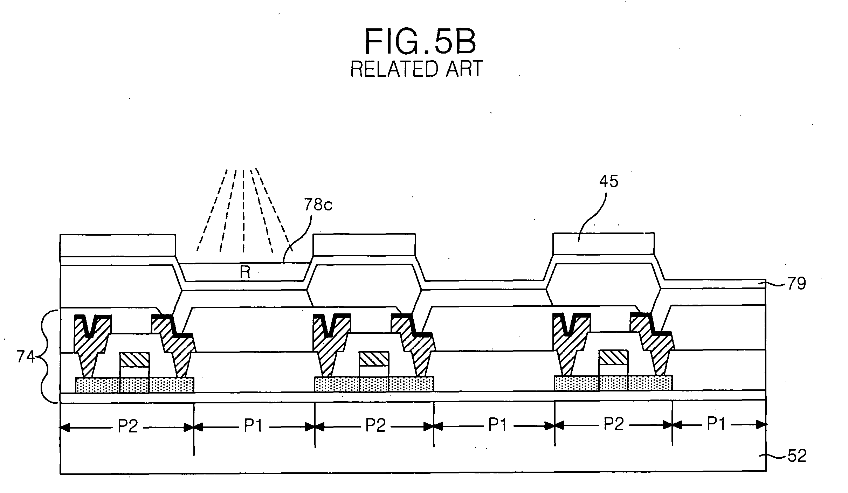

This will be described in detail with reference to Fig. 5A and Fig. 5B below.

Firstly, a common mask 35 is aligned on the substrate 52 provided with the first electrode 100. Thereafter, the hole injection layer and the hole carrier layer (hereinafter referred to as " first organic material" 79) are formed at the entire surface of the organic EL array 60. Herein, the common mask 35 entirely exposes the organic EL array area 60, so that the first organic material 79 is deposited onto the light-emitting area P1 provided with the first electrode 100 as well as a non-emitting area P2 as shown in Fig. 5A.

Subsequently, a shadow mask 45 is aligned at the upper portion of the substrate 52, and a specific light-emitting layer 78c, for example, a light-emitting layer 78c for implementing a red(R) color as shown in Fig. 5B is formed at an area exposed through a transmitting part 46 of the mask 45. Then, the same mask 45 is sequentially moved to provide a light-emitting layer 78c for implementing a green(G) color and a light-emitting layer 78c for implementing a blue(B) color. Herein, since the shadow mask 45 comes in contact with the first organic material 79 provided at the non-emitting layer P2, for example, upon formation of the light-emitting layer 78c implementing the red(R) color, the first organic material 79 is torn due to a small impact and a process margin, etc. to be adhered onto the shadow mask 45. When the blue and green light-emitting layers 78c are formed by sequentially moving the shadow mask 45 adhered with the first organic material 79, the first organic material 79 adhered onto the shadow mask 45 causes a damage to an organic material provided at the light-emitting area P1. This generates a scratch at the light-emitting layer and further exposes the first electrode 100 in a serious case, thereby raising a poor pixel problem such as an electrical conduction between the first electrode 100 and the second electrode 70 to be formed later.

### SUMMARY OF THE INVENTION

Accordingly, it is an object of the present invention to provide an organic electro-luminescence display device and a fabricating method thereof that are adaptive for preventing a damage of organic light-emitting layer and hence preventing a pixel badness.

In order to achieve these and other objects of the invention, an organic electro-luminescence display device according to one aspect of the present invention includes a thin film transistor array provided on a substrate; a first electrode connected to the thin film transistor; at least one insulating film for exposing the first electrode and separating each pixel; an organic light-emitting layer overlapping with the first electrode; and a second electrode provided on the organic light-emitting layer.

In the organic electro-luminescence device, said at least one insulating film includes a first insulating film for separating each pixel; and a second insulating film provided on the first insulating film.

Herein, each of the first and second insulating film has a height of approximately 1~5µm.

The organic electro-luminescence device further includes a spacer provided on the insulating film.

Herein, the spacer has a height of approximately 2~7µm.

A method of fabricating an organic electro-luminescence device according to another aspect of the present invention includes the steps of forming a thin film transistor array on a substrate; forming a first electrode connected to the thin film transistor; forming at least one insulating film for exposing the first electrode and separating each pixel; forming an organic light-emitting layer overlapping with the first electrode; and forming a second electrode on the organic light-emitting layer.

In the method, said step of forming said at least one insulating film includes forming a first insulating film for separating each pixel; and forming a second insulating film on the first insulating film.

In the method, each of the first and second insulating film has a height of approximately 1~5µm.

The method further includes the step of forming a spacer on the insulating film.

In the method, the spacer has a height of approximately 2~7µ m.

### BRIEF DESCRIPTION OF THE DRAWINGS

These and other objects of the invention will be apparent from the following detailed description of the embodiments of the present invention with reference to the accompanying drawings, in which:

Fig. 1 is a schematic section view showing a structure of a related art organic electro-luminescence display device;

Fig. 2 is a view for explaining a light-emitting principle of the related art organic electro-luminescence display device;

Fig. 3 is a circuit diagram representing a pixel of a related art active matrix organic electro-luminescence display device;

Fig. 4A to Fig. 4E are views representing a method of fabricating the related art organic electro-luminescence display device;

Fig. 5A and Fig. 5B are views for specifically explaining a formation of the organic light-emitting layer;

Fig. 6 is a section view showing a structure of an organic electro-luminescence array of an organic electro-luminescence display device according to a first embodiment of the present invention;

Fig. 7A to Fig. 7F are views representing a method of fabricating the organic electro-luminescence display device shown in Fig. 6 step by step;

Fig. 8 is a section view showing a structure of an organic electro-luminescence array of an organic electro-luminescence display device according to a second embodiment of the present invention;

Fig. 9 is a plan view of the organic electro-luminescence array shown in Fig. 8; and

Fig. 10A to Fig. 10D are views representing a method of fabricating the organic electro-luminescence display device shown in Fig. 8 step by step.

### DETAILED DESCRIPTION OF THE PREFERRED EMBODIMENT

Reference will now be made in detail to the preferred embodiments of the present invention, examples of which are illustrated in the accompanying drawings.

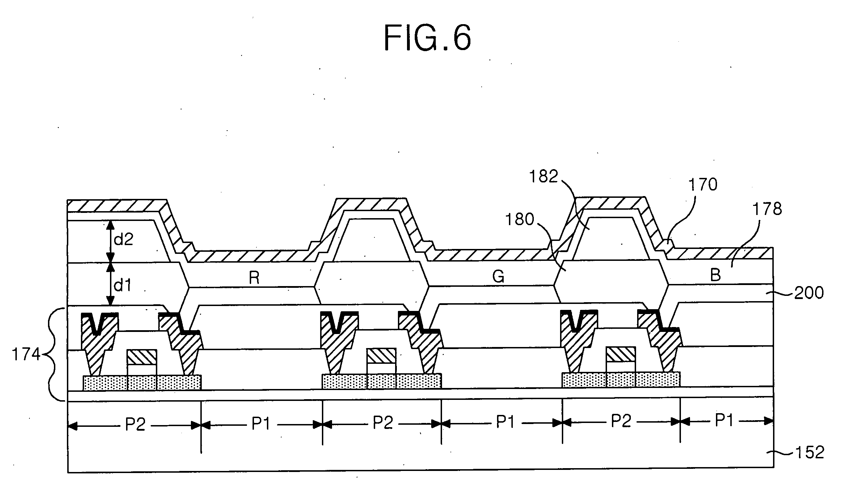

Hereinafter, the preferred embodiments of the present invention will be described in detail with reference to Figs. 6 to 10D.

Fig. 6 shows a structure of an organic light-emitting array of an active matrix organic electro-luminescence (EL) display device according to a first embodiment of the present invention.

The active matrix organic EL display device includes an organic EL array 160 shown in Fig. 6, and a cap (not shown) for packaging the organic EL array 160.

Referring to Fig. 6, the organic EL array of the active matrix organic EL display device includes an array part 174 having switching and driving thin film transistors T provided at the upper portion of a transparent substrate 152, and a first electrode 200, first and second insulating films 180 and 182 for separating each pixel, an organic light-emitting layer 178 and a second electrode 170 provided at the upper portion of the thin film transistor (T) array part 74.

The organic light-emitting layer 178 consists of a hole injection layer, a hole carrier layer, a light-emitting layer, an electron carrier layer and an electron injection layer, etc.

If a voltage is applied between the first electrode 200 and the second electrode 170 of the organic EL array 160, then electrons generated from the second electrode 170 are moved, via the electron injection layer and the electron carrier layer, into the light-emitting layer. Further, holes generated from the first electrode 200 are moved, via the hole injection layer and the hole carrier layer, into the light-emitting layer. Thus, electrons and holes fed from the electron carrier layer and the hole carrier layer are collided and re-combined with each other to thereby generate a light. This light is emitted, via the first electrode 200, into the exterior to thereby display a picture.

Meanwhile, the first insulating film 180 of the organic EL array 160 plays a role to expose the first electrode 200 and separate each pixel P.

The second insulating film 182 is provided on the first insulating film 180 in such a manner to have a predetermined height, thereby playing a role to separate each pixel and prevent a pixel badness upon formation of the organic light-emitting layer 178.

More specifically, a common mask is aligned on a substrate 152 provided with the first electrode 200. Thereafter, the hole injection layer and the hole carrier layer (hereinafter referred to as " first organic material" ) are formed at the entire surface of the organic EL array 160. Subsequently, a shadow mask is sequentially moved to provide a light-emitting layer for implementing red, green and blue colors. Herein, since the shadow mask comes in contact with the first organic material provided on the second insulating film 182 at a non-emitting area, the first organic material is adhered onto the shadow mask. Thereafter, the shadow mask is sequentially moved to provide the second insulating film 182 having a predetermined height on the first insulating film 180, for example, when the green and blue light-emitting layers are formed, so that a distance between the shadow mask and the first electrode becomes sufficiently far away from each other.

Accordingly, even though the shadow mask adhered with the first organic material is moved, a contact of the first organic material with an organic material positioned on the first electrode 200 does not occur because a distance between the shadow mask and the first electrode 200 is sufficiently far away from each other. Thus, a damage of the organic light-emitting layer 178 is prevented, so that a pixel badness such as a conduction between the first electrode 200 and the second electrode 170 does not occur. Herein, each height d1 and d2 of the first and second insulating films 180 and 182 is approximately 1~5µ m, preferably 2~3µm.

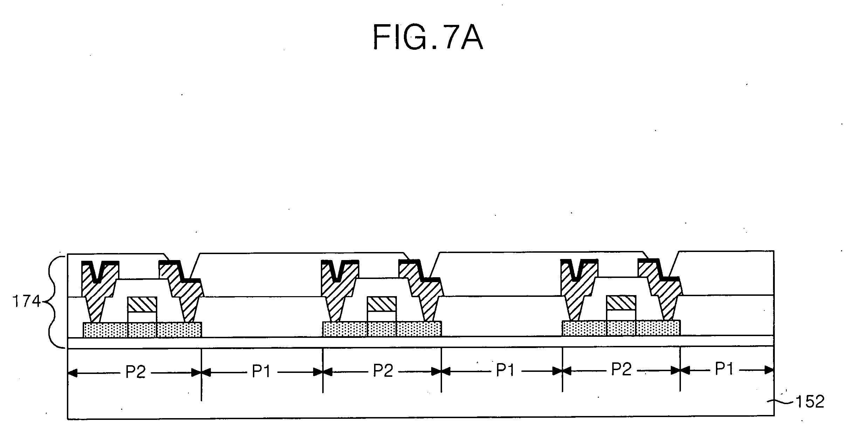

Fig. 7A to Fig. 7F are views for explaining a method of fabricating an active matrix organic EL display device according to a first embodiment of the present invention.

Firstly, as shown in Fig. 7A, the thin film transistor (T) array part 174 is provided on the substrate 152. Herein, the thin film transistor (T) array part 174 includes a thin film transistor T consisting of the gate electrode, the drain electrode, the source electrode and the semiconductor pattern, etc., and signal lines such as the gate line, etc.

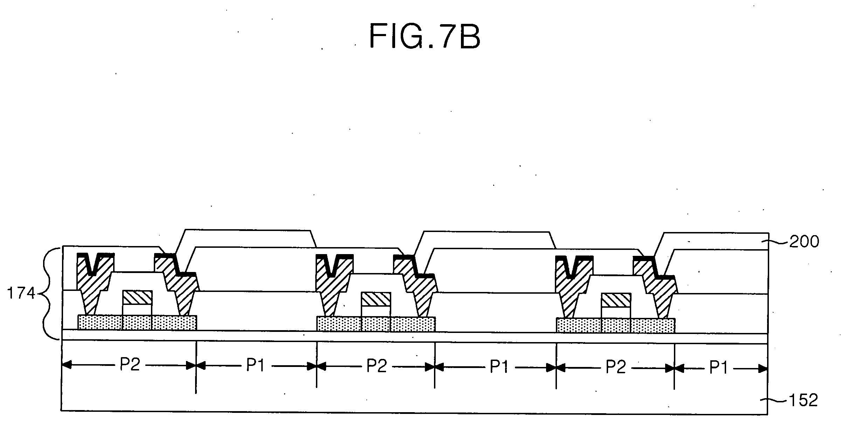

A transparent electrode material is entirely deposited onto the substrate 152 provided with the thin film transistor (T) array part 174 by a deposition technique such as the sputtering, etc. Then, the transparent electrode material is patterned by the photolithography and the etching process. Thus, as shown in Fig. 7B, the first electrode 200 connected to the thin film transistor T and positioned at a light-emission area P1 is provided. Herein, the transparent electrode material is made from indium-tin-oxide (ITO), tin-oxide (TO), indium-zinc-oxide (IZO) or the like.

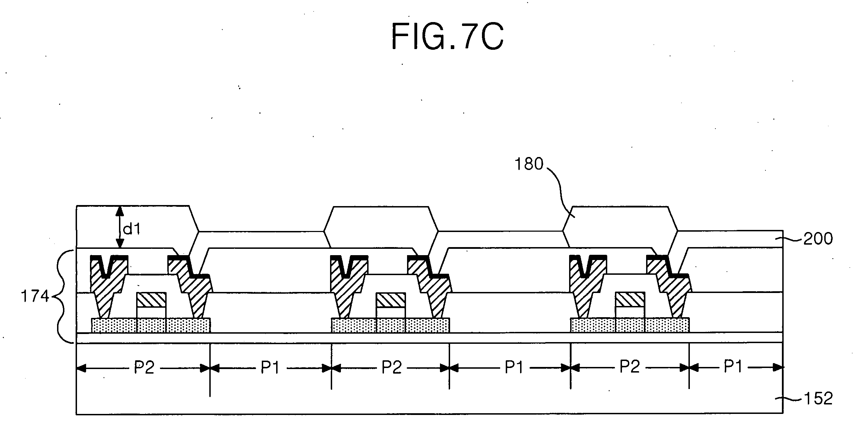

A photo-sensitive insulating material such as polyimide, etc. is deposited onto the substrate 152 provided with the first electrode 200 and then is patterned by the photolithography, thereby providing the first insulating film 180 exposing the first electrode 200 at the light-emission area P1 as shown in Fig. 7C.

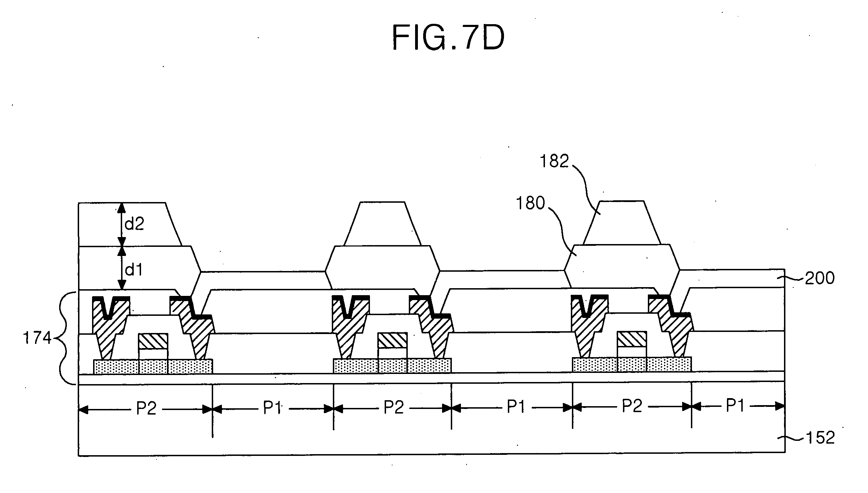

A photo-sensitive insulating material such as polyimide, etc. is deposited onto the substrate 152 provided with the first insulating film 180 and then is patterned by the photolithography, thereby providing the second insulating film 182 on the first insulating film 180 as shown in Fig. 7D.

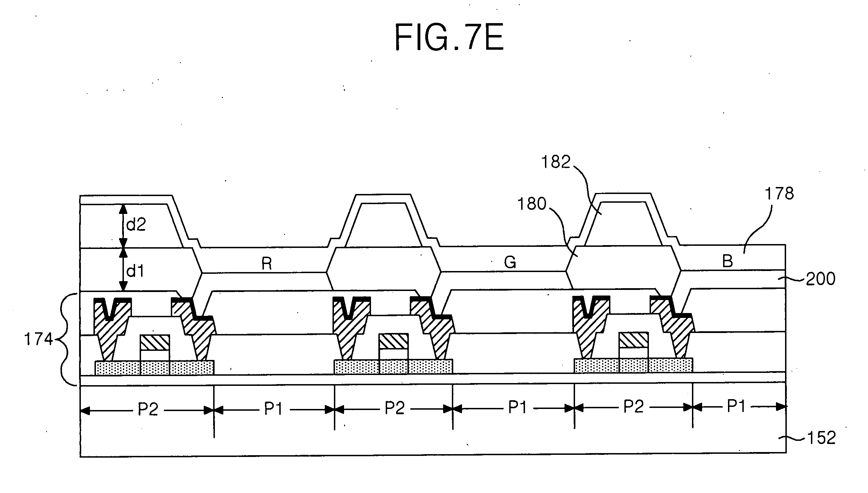

Red(R), green(G) and blue(B) organic materials are deposited onto the substrate 152 provided with the first and second insulating films 180 and 182 by a deposition technique such as a vacuum deposition and a thermal growing deposition, etc., thereby providing an organic light-emitting layer 178 as shown in Fig. 7E. The organic light-emitting layer 178 consists of a hole carrier layer, a hole injection layer, a light-emitting layer, an electron carrier layer and an electron injection layer, etc. Herein, the common mask for entirely exposing the organic EL array is used in the case of forming the hole carrier layer, the hole injection layer, the electron carrier layer and the electron injection layer, whereas the shadow mask for exposing only a specific light-emitting area is used in the case of forming the light-emitting layer.

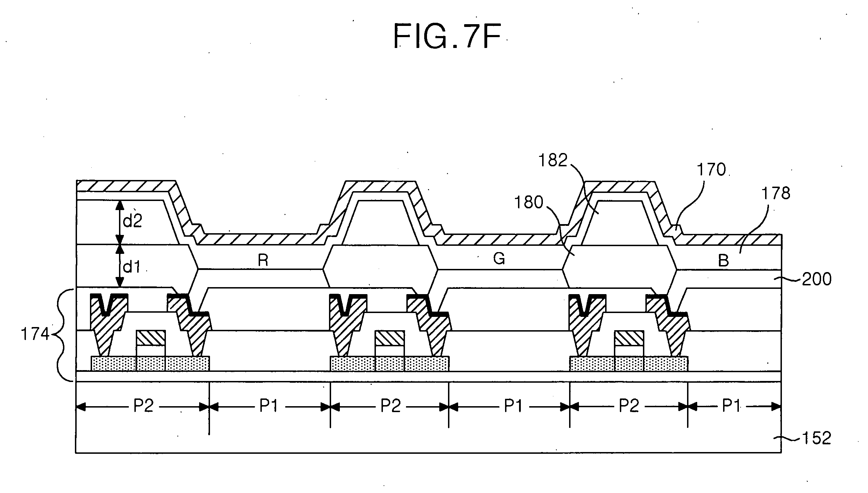

Subsequently, a conductive metal material is deposited onto the organic light-emitting layer 178 by a deposition technique such as the sputtering, etc. to thereby provide the second electrode 170 as shown in Fig. 7F. Herein, the conductive metal material is made from any one selected from aluminum (Al), calcium (Ca) and magnesium (Mg), or is formed by a double metal layer of ritum-fluorine/aluminum (LiF/Al). Thus, the organic EL array 160 is provided.

The organic EL array 160 provided with the thin film transistor (T) array part 174 through the second electrode 170 in this manner is packaged by a cap (not shown), thereby providing the active matrix organic EL display device.

As described above, in the organic EL display device and the fabricating method thereof according to the first embodiment of the present invention, the second insulating film 182 having a predetermined height is further provided on the first insulating film 180. The second insulating film 182 plays a role to sufficiently space a distance between the shadow mask and the organic material on the first electrode 200 upon formation of the organic light-emitting layer 178. Accordingly, a damage of the organic light-emitting layer 178 caused by the first organic material adhered onto the shadow mask upon formation of the organic light-emitting layer 178 can be prevented, so that it becomes possible to prevent a pixel badness such as a conduction between the first and second electrodes.

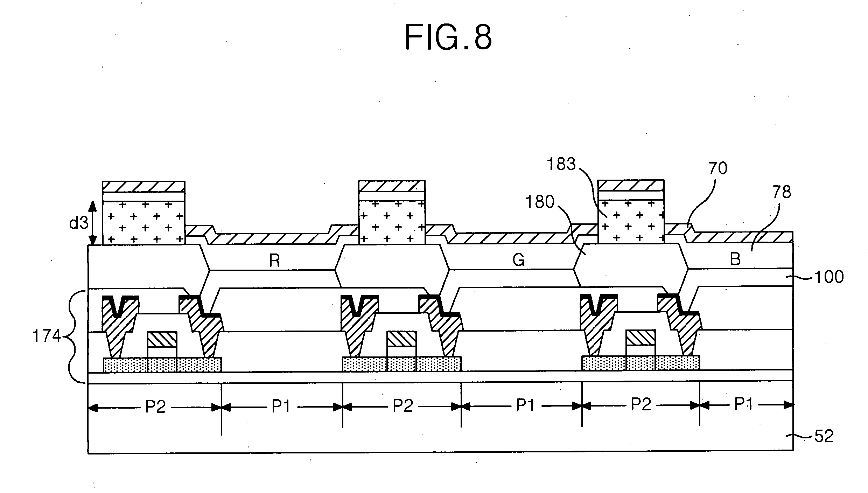

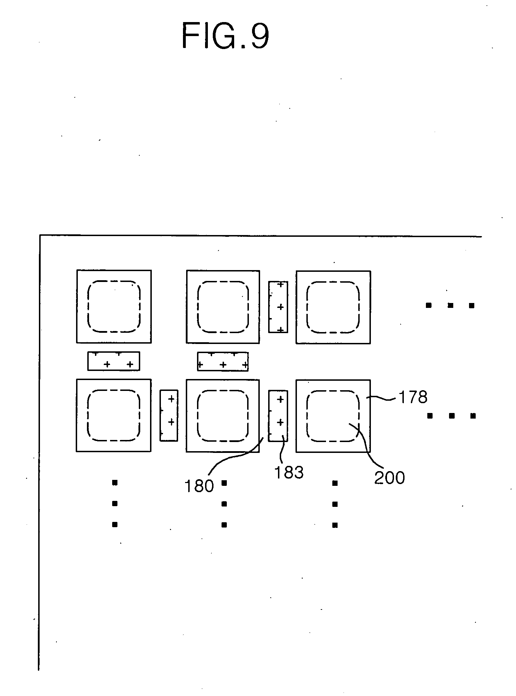

Fig. 8 is a section view showing a structure of an organic electro-luminescence array of an organic electro-luminescence display device according to a second embodiment of the present invention, and Fig. 9 is a plan view of the organic electro-luminescence array shown in Fig. 8.

The organic EL array 160 shown in Fig. 8 has the same elements as the organic EL array shown in Fig. 6 except that a spacer 183 is replaced by the second insulating film 182. The same numerals will be given to the same elements, and a detailed explanation as to the same elements will be omitted.

In the organic EL array 160 shown in Fig. 8, a spacer 183 having a predetermined height is provided on the first insulating film 180. This spacer 183 has a height d3 of about 2~7µm, preferably 3~6µm. In other words, the spacer 183 is formed at a relatively larger height than the second insulating film 183 in the first embodiment, so that the organic light-emitting layer 178 and the second electrode 170 are partially broken from each other at an area provided with the spacer 183. As shown in Fig. 9, at least one of spacer 183 is provided on the first insulating film 180 on a random basis, so that it plays a role to sufficiently estrange a distance between the shadow mask and the organic material on the first electrode 200 upon formation of the organic light-emitting layer 178. Accordingly, a damage of the organic light-emitting layer 178 caused by the first organic material adhered onto the shadow mask upon formation of the organic light-emitting layer 178 can be prevented, so that it becomes possible to prevent a pixel badness such as a conduction between the first and second electrodes 200 and 170.

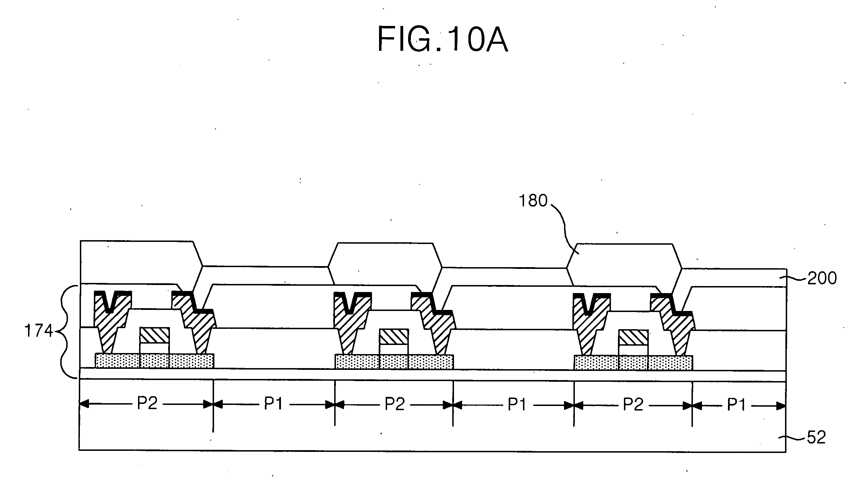

Fig. 10A to Fig. 10D are views for explaining a method of fabricating the organic electro-luminescence display device according to the second embodiment of the present invention.

Firstly, as shown in Fig. 10A, the thin film transistor (T) array part 174, the first electrode 200 and the first insulating film 180 are provided on the substrate 152 in a similar manner to Fig. 7A to Fig. 7C in the first embodiment of the present invention.

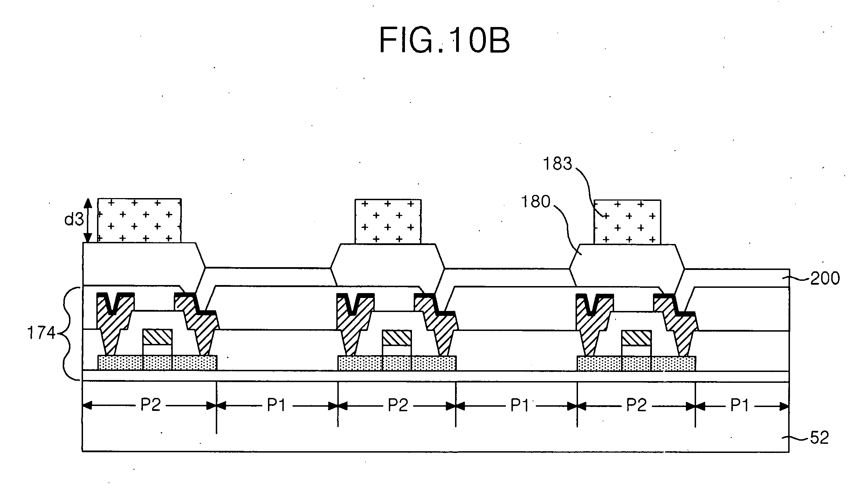

Thereafter, a photo-sensitive insulating material such as polyimide, etc. is deposited and then is patterned by the photolithography, thereby providing the spacer 183 on the first insulating film 180 as shown in Fig. 10B. Herein, unlike the second insulating film 182 in the first embodiment, at least one of spacer 183 is formed on the first insulating film 182 on a random basis in such a manner to have a height d3 of about 2~7µ m, preferably 3~6µm.

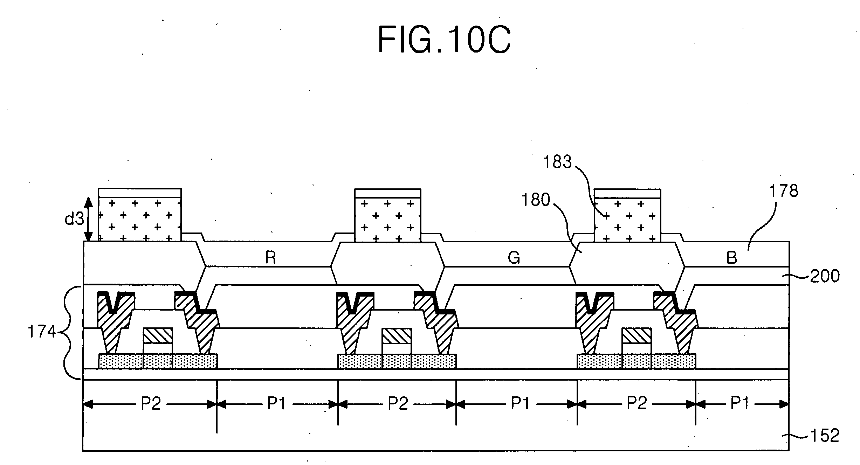

Red(R), green(G) and blue(B) organic materials are deposited onto the substrate 152 provided with the spacer 183 by a deposition technique such as a vacuum deposition and a thermal growing deposition, etc., thereby providing an organic light-emitting layer 178 as shown in Fig. 10C. The organic light-emitting layer 178 consists of a hole carrier layer, a hole injection layer, a light-emitting layer, an electron carrier layer and an electron injection layer, etc, and is provided in such a manner to be partially broken due to a step coverage of the spacer 183 at an area provided with the spacer 183. Herein, the common mask for entirely exposing the organic EL array is used in the case of forming the hole carrier layer, the hole injection layer, the electron carrier layer and the electron injection layer, whereas the shadow mask for exposing only a specific light-emitting area is used in the case of forming the light-emitting layer.

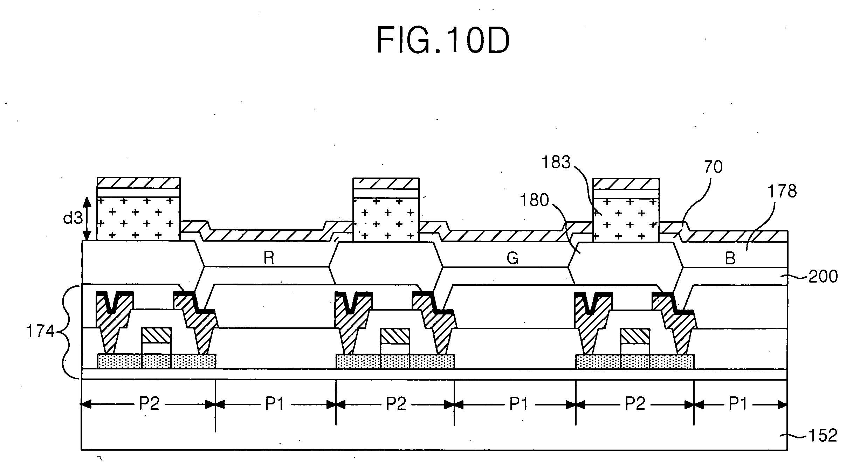

Subsequently, a conductive metal material is deposited onto the organic light-emitting layer 178 by a deposition technique such as the sputtering, etc. to thereby provide the second electrode 170 as shown in Fig. 10D. Herein, the conductive metal material is made from any one selected from aluminum (Al), calcium (Ca) and magnesium (Mg), or is formed by a double metal layer of ritum-fluorine/aluminum (LiF/Al). Thus, the organic EL array 160 is provided.

The organic EL array 160 provided with the thin film transistor (T) array part 174 through the second electrode 170 in this manner is packaged by a cap (not shown), thereby providing the active matrix organic EL display device.

As described above, in the organic EL display device and the fabricating method thereof according to the embodiments of the present invention, any at least one of the second insulating film 182 and the spacer 183 having a predetermined height is provided on the first insulating film 180. Each of the second insulating film 182 and the spacer 183 plays a role to sufficiently estrange a distance between the shadow mask and the organic material on the first electrode 200 upon formation of the organic light-emitting layer 178. Accordingly, a damage of the organic light-emitting layer 178 caused by the first organic material adhered onto the shadow mask upon formation of the organic light-emitting layer 178 can be prevented, so that it becomes possible to prevent a pixel badness such as a conduction between the first and second electrodes 200 and 170.

As described above, according to the present invention, the insulating film is formed into a double layer or the spacer is formed on the insulating film, thereby sufficiently estranging a distance between the mask and the electrode. Accordingly, it becomes possible to prevent a damage of the organic light-emitting layer as well as a pixel badness caused by a conduction between the first and second electrodes, etc.

Although the present invention has been explained by the embodiments shown in the drawings described above, it should be understood to the ordinary skilled person in the art that the invention is not limited to the embodiments, but rather that various changes or modifications thereof are possible without departing from the spirit of the invention. Accordingly, the scope of the invention shall be determined only by the appended claims and their equivalents.

## Claims

1. An organic electro-luminescence device, comprising:
a thin film transistor array provided on a substrate;
a first electrode connected to the thin film transistor;
at least one insulating film for exposing the first electrode and separating each pixel;
an organic light-emitting layer overlapping with the first electrode; and
a second electrode provided on the organic light-emitting layer.

2. The organic electro-luminescence device according to claim 1, wherein said at least one insulating film includes:
a first insulating film for separating each pixel; and
a second insulating film provided on the first insulating film.

3. The organic electro-luminescence device according to claim 2, wherein each of the first and second insulating film has a height of approximately 1~5µm.

4. The organic electro-luminescence device according to claim 1, further comprising:
a spacer provided on the insulating film.

5. The organic electro-luminescence device according to claim 4, wherein the spacer has a height of approximately 2~7µ m.

6. A method of fabricating an organic electro-luminescence device, comprising the steps of:
forming a thin film transistor array on a substrate;
forming a first electrode connected to the thin film transistor;
forming at least one insulating film for exposing the first electrode and separating each pixel;
forming an organic light-emitting layer overlapping with the first electrode; and
forming a second electrode on the organic light-emitting layer.

7. The method according to claim 6, wherein said step of forming said at least one insulating film includes:
forming a first insulating film for separating each pixel; and
forming a second insulating film on the first insulating film.

8. The method according to claim 7, wherein each of the first and second insulating film has a height of approximately 1~5µ m.

9. The method according to claim 6, further comprising the step of:
forming a spacer on the insulating film.

10. The method according to claim 9, wherein the spacer has a height of approximately 2~7µ m.
